# EUROPÄISCHE PATENTSCHRIFT

(11) **EP 1 240 812 B1**
(45) Veröffentlichungstag und Bekanntmachung des Hinweises auf die Patenterteilung: **06.08.2003**
(21) Anmeldenummer: 00991112.4
(22) Anmeldetag: 20.12.2000
(51) Int. Cl.: H05K 13/04

(54) **BESTÜCKKOPF MIT EINER VERDREHEINRICHTUNG FÜR ELEKTRISCHE BAUELEMENTE**
INSERTION HEAD COMPRISING A ROTATIONAL DEVICE FOR ELECTRIC COMPONENTS
TETE D'INSERTION DOTEE D'UN DISPOSITIF D'ORIENTATION POUR COMPOSANTS ELECTRIQUES

(30) Priorität: 21.12.1999 DE 19961778
(43) Veröffentlichungstag der Anmeldung: 18.09.2002
(73) Patentinhaber: SIEMENS AKTIENGESELLSCHAFT, 80333 München (DE)
(72) Erfinder: SCHULZ, Ralf, 81241 München (DE); MEHDIANPOUR, Mohammad, 81829 München (DE); HUBER, Wolfgang, 81379 München (DE)
(86) Internationale Anmeldenummer: DE0004576
(87) Internationale Veröffentlichungsnummer: WO01047334

(56) Entgegenhaltungen:
- EP-A- 0 691 805
- EP-A- 0 906 011
- FR-A- 2 661 309

## Beschreibung

Die Erfindung bezieht sich auf einen Bestückkopf mit zumindest einer Verdreheinrichtung für elektrische Bauelemente, wobei der revolverartige Bestückkopf einen Stator und einen Rotor aufweist, an eine Vielzahl von zirkulär verteilten Greifern in sich um eine Aufsetzachse drehbar gelagert sind, wobei der Bestückkopf eine optische Meßeinrichtung zur Lageerkennung der an den Greifern gehaltenen Bauelemente aufweist und
wobei die Bauelemente nach dem optischen Vermessen durch eine Feindreheinrichtung genau in die geforderte Aufsetzlage verdrehbar sind.

Durch die EP 0 315 799 B ist es bekannt, eine Bestückvorrichtung mit einem verfahrbaren Revolverkopf zu versehen, bei dem die mit Saugpipetten versehenen Greifer an einem Rotor sternförmig abstehend angeordnet sind. Ein Stator des Bestückkopfes ist mit umlaufend verteilten Bearbeitungsstationen versehen.

Es ist z.B. nach der EP 0906011 A üblich, eine dieser Stationen als optische Meßstation auszubilden, in der die Drehlage des zuvor aufgenommenen Bauelementes ermittelt wird. In einer nachfolgenden Verdrehstation wird die Lage des Bauelementes entsprechend der gewünschten Einbaulage verändert. Diese Veränderung beinhaltet eine Grobverdrehung z.B. in 45° Schritten entsprechend der gewünschten Einbaulage sowie eine Feinverdrehung, durch die die Abholungenauigkeit beim Aufnehmen der Bauelemente aus einer Zuführeinrichtung ausgeglichen wird.

Es ist ferner üblich, den Greifer mit einem scheibenartigen Drehkranz von relativ großem Durchmesser zu versehen. Auf diesen kann ein Reibrad der Dreheinrichtung radial aufgesetzt werden, worauf die Dreheinrichtung aktiviert wird und eine exakte Verdrehung des Greifers um einen vorberechneten Winkel bewirkt. Da die Bauelemente in unterschiedlicher Einbaulage auf die Leiterplatte aufzusetzen sind, kann der Drehwinkel so groß sein, daß der gesamte Drehzyklus länger dauert, als die Arbeitszyklen an anderen Stationen des Revolverkopfes, wodurch dessen Bestückleistung entsprechend begrenzt wird.

Der Erfindung liegt die Aufgabe zugrunde, den Zeitverlust beim Verdrehen der Greifer zu verringern.

Diese Aufgabe wird durch die Erfindung gemäß Anspruch 1 gelöst. Das Verdrehen des Greifers verteilt sich nun auf zwei Stufen, wobei die Grobverdrehung ohne besondere Genauigkeit zügig in einem Drehsegment vor optischen Meßeinrichtung erfolgt. Dadurch kann auch bei einem großen Gesamtdrehwinkel der Drehwinkel in der Feindreheinrichtung soweit verkürzt werden, daß die Feineinstellung nicht länger dauert als z.B. als das optische Vermessen in der Meßeinrichtung.

Vorteilhafte Weiterbildungen der Erfindung sind in den Unteransprüchen gekennzeichnet.

Durch die Weiterbildung nach Anspruch 2 erfolgt das Vermessen und das Feinverdrehen der Bauelemente im Stillstand. Die Meßstation und Feindrehstation wie auch die Grobdrehstation nach Anspruch 3 sind in einfacher Weise am Stator befestigt und können mit dem Bauelement bzw. mit dem Greifer eine präzise Wirkverbindung eingehen.

Durch die Reibfläche nach Anspruch 4 erfolgt die Grobdrehung während der ohnehin erforderlichen Vorwärtsbewegung des Greifers ohne jeden Zeitverlust. Die stationäre Reibfläche kann an einem einfachen Konstruktionsteil ausgebildet sein, an dem der Drehkranz solange abrollt, bis die gewünschte Endstellung zumindest annähernd erreicht ist. Die Eingriffslänge zwischen der Reibfläche und dem Drehkranz kann durch eine radiale Zustellbewegung der Verdreheinrichtung z.B. mit Hilfe von piezoelektrischen Antriebselementen von kurzer Reaktionszeit genau terminiert werden, so daß der Greifer um den berechneten Winkel verdreht werden kann.

Durch die Weiterbildung nach Anspruch 5 ist es möglich, die Grobverdrehung mit geringem Steuerungsaufwand durchzuführen.

Der Reibklotz nach Anspruch 6 stellt ein einfaches, leicht zu betätigendes Bauteil dar.

Durch die Weiterbildung nach Anspruch 7 ist es möglich, die Länge der Reibflächen so auszubilden, daß am Greifer jeweils ein Drehwinkel von z.B. 45° erreicht wird. Eine Vervielfachung des Drehwinkels wird durch eine entsprechende Anzahl der in die Bewegungsbahn des Drehkranzes schaltbar verstellten Reibklötze möglich.

Durch die Weiterbildung nach Anspruch 8 ist sichergestellt, daß die Greifer mit den Drehkränzen entlang einer genau definierten Bahn bewegt werden können. Zum Beispiel bewegen sich bei einem sternförmigen Revolverkopf mit radial abstehenden Greifern die Drehkränze in einer Ebene, so daß auch die Reibklötze in einer Ebene angeordnet werden können, was mit Montagevorteilen verbunden ist. Durch die Verkürzung der Reiblänge wird sichergestellt, daß jede Reibfläche jeweils nur von einem Drehkranz belegt wird. Dadurch können diese je nach Vorgabe unterschiedlich und individuell verdreht werden.

Im folgenden wird die Erfindung anhand eines in der Zeichnung dargestellten Ausführungsbeispieles näher erläutert.
- Figur 1: zeigt eine Seitenansicht eines Bestückkopfes zum Bestücken von elektrischen Leiterplatten mit Bauelementen,
- Figur 2: eine andere Seitenansicht des Bestückkopfes nach Figur 1.

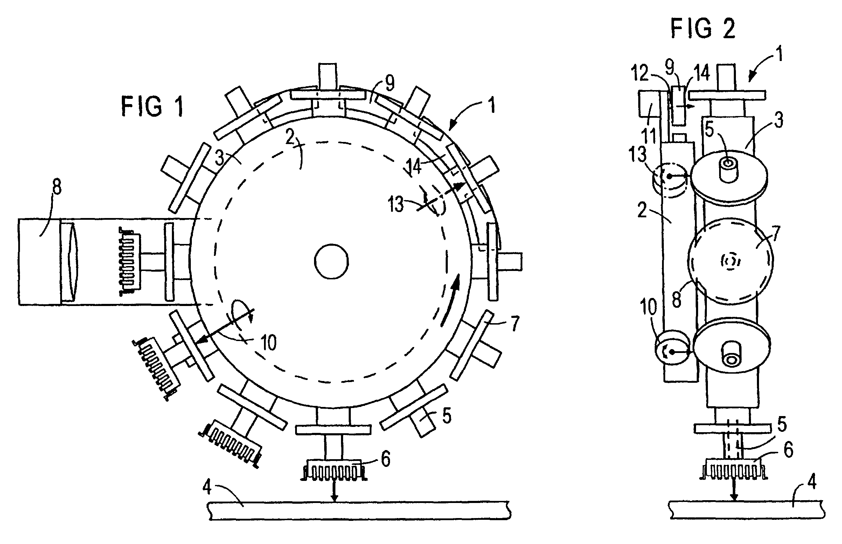

Nach den Figuren 1 und 2 besteht ein revolverkopfartiger Bestückkopf 1 aus einem Stator 2 und einem Rotor 3. Der Bestückkopf ist über einer Leiterplatte 4 verfahrbar und weist radial sternförmig abstehende Greifern 5 auf, die mit Saugpipetten versehen sind, an deren freien Enden elektrische Bauelemente 6 gehalten sind. Der Rotor kann schrittweise um einen Indexwinkel verdreht werden, der dem Teilungswinkel der Greifer 5 entspricht. Die Greifer 5 sind teleskopartig aus dem Rotor herausschiebbar. Der jeweils in der Aufsetzstellung befindliche Greifer 5 kann somit das Bauelement 6 in dargestellten senkrechten Pfeilrichtung auf die Leiterplatte 4 aufsetzen.

Die drehbar gelagerten Greifer 5 sind mit scheibenartig geformten Drehkränzen 7 versehen. Eine optische Meßstation 8 dient dem Messen der Lage der Bauelemente 6 gegenüber dem Greifer 5. Entlang der Bewegungsbahn der Drehkränze 7 sind am Stator 2 Reibklötze 9 angebracht, die in der waagerechten Pfeilrichtung soweit ausgelenkt werden können, daß ihre Reibflächen 14 auf die Drehkränze 7 aufgesetzt werden können. Beim Verdrehen des Rotors 3 rollen somit die Drehkränze 7 mit ihren Mantelflächen auf den Reibflächen 14 ab und werden entsprechend verdreht. Dieses Verdrehen geschieht zeitsparend zwischen den Haltestationen des Rotors 3. Die Länge der Reibklötze 9 ist so bemessen, daß die Greifer 5 jeweils um z.B. 45° verdreht werden.

Durch Ein- und Ausschalten der Bremsklotzzustellung kann der Greifer um ein beliebiges Vielfaches des Grobdrehwinkels verdreht werden. Im Anschluß an diese Grobdrehung werden die Bauelemente 6 in der Optikstation vermessen und ihre Abweichung von der Einbaulage bestimmt. Eine nachfolgende Feindreheinrichtung 10 ist einer der Haltestationen zugeordnet. In ihr kann die Drehstellung des Greifers 5 feinstufig verändert und auch die gewünschte Einbaulage des Bauelements korrigiert werden.

Die Reibklötze 9 sind Teil einer Grobdreheinrichtung 11 und mit dieser über piezoelektrische Antriebselemente 12 verbunden, die dem Reibklotz 9 in die Richtung des Drehkranzes 7 verstellen.

Anstelle der Grobdreheinrichtung 11 mit den Reibklötzen 8 kann auch eine strichpunktiert angedeutete Grobdrehstation (13) am Stator an einer Haltestation der Greifer 5 angeordnet sein, die gleich der Feindrehstation 10 ausgebildet ist.

## Patentansprüche

1. Bestückkopf (1) mit zumindest einer Verdreheinrichtung (10, 11) für elektrische Bauelemente (6), wobei der revolverartige Bestückkopf (1) einen Stator (2) und einen Rotor (3) aufweist, an dem eine Vielzahl von zirkulär verteilten Greifern (5) in sich um eine Aufsetzachse drehbar gelagert sind,
wobei der Bestückkopf (1) eine optische Meßeinrichtung (8) zur Lageerkennung der an den Greifern (5) gehaltenen Bauelemente (6) aufweist,
wobei der Bestückkopf (1) eine in der Verdrehrichtung des Rotors (3) der Meßeinrichtung (8) nachfolgend angeordnete Feindreheinrichtung (10) zum genauen Verdrehen der Bauelemente (6) um die Aufsetzachse in die geforderte Aufsetzlage aufweist,
**dadurch gekennzeichnet,**
**daß** der Bestückkopf (1) eine in der Verdrehrichtung Rotors (3) der Meßeinrichtung (8)vorangehend angeordnete Grobdreheinrichtung (11) zum Verdrehen der Bauelemente (6) um die Aufsetzachse in eine der Aufsetzlage angenäherte Winkellage aufweist.

2. Bestückkopf nach Anspruch 1.
**dadurch gekennzeichnet,**
**daß** der Rotor (3) gegenüber dem Stator (2) schrittweise verdrehbar ist,
**daß** die die optische Meßeinrichtung als Meßstation (8) und
**daß** die Feindreheinrichtung (10) als am Stator verankerte Feindrehstation (10) ausgebildet ist.

3. Bestückkopf nach Anspruch 2,
**dadurch gekennzeichnet,**
**daß** die am Stator verankerte Grobdreheinrichtung als einer Haltestation der Greifer (5) zugeordnete Grobdrehstation (13) ausgebildet ist.

4. Bestückkopf nach Anspruch 3,
wobei der Greifer (5) einen Drehkranz (7) aufweist, der peripher mit zumindest einer Reibfläche (14) der Verdreheinrichtung (10, 11) reibschlüssig in Eingriff bringbar ist,
wobei die Reibfläche (14) in radialer Richtung auf den Drehkranz (7) aufsetzbar ist und
wobei der Greifer (5) durch eine tangentiale Relativbewegung zwischen der Verdreheinrichtung (10, 11) und dem Drehkranz (7) verdrehbar ist,
**dadurch gekennzeichnet,**
**daß** sich die stationäre Reibfläche (14)der Grobdreheinrichtung (11) entlang der Bewegungsbahn des zusammen mit dem Rotor (3) verdrehbaren Greifers (5) erstreckt und
**daß** die Abwälzstrecke auf der Reibfläche (14) durch die gesteuerte Zustellung der Reibfläche (14) auf den Drehkranz (7) veränderbar ist.

5. Bestückkopf nach Anspruch 4,
**dadurch gekennzeichnet,**
**daß** die Grobdreheinrichtung (11) eine Drehverstellung des Greifers (5) in groben Basisschritten ermöglicht.

6. Vorrichtung nach Anspruch 4 oder 5,
**dadurch gekennzeichnet,**
**daß** die Reibfläche (14) an einem am Stator verankerten, radial verstellbaren Reibklotz (9) ausgebildet ist.

7. Einrichtung nach Anspruch 6,
**dadurch gekennzeichnet,**
**daß** die segmentierte Reibfläche (14) von mehreren einzeln verstellbaren Reibklötzen (9) gebildet ist, deren Reiblänge den dem Drehwinkel eines Basisschrittes entspricht.

8. Einrichtung nach Anspruch 6 oder 7,
**dadurch gekennzeichnet,**
**daß** die Reibflächen (14) kürzer sind, als der Abstand zwischen zwei der einander benachbarten Drehkränze (7).

## Claims

1. Insertion head (1) comprising at least one rotational device (10, 11) for electric components (6), the turret-like insertion head (1) having a stator (2) and a rotor (3), on which a multiplicity of circularly distributed grippers (5) are mounted independently rotatably about a placement axis, the insertion head (1) having an optical measuring device (8) for detecting the position of the components (6) held on the grippers (5), the insertion head (1) having a fine rotational device (10), arranged after the measuring device (8) in the direction of rotation of the rotor (3), for precisely rotating the component (6) about the placement axis into the required placement position, **characterized in that** the insertion head (1) has a coarse rotational device (11), arranged ahead of the measuring device (8) in the direction of rotation of the rotor (3), for rotating the components (6) about the placement axis into an angular position approximate to the placement position.

2. Insertion head according to Claim 1, **characterized in that** the rotor (3) can be rotated step by step with respect to the stator (2), **in that** the the optical measuring device is designed as a measuring station (8) and **in that** the fine rotational device (10) is designed as a fine rotational station (10) anchored on the stator.

3. Insertion head according to Claim 2, **characterized in that** the coarse rotational device anchored on the stator is designed as a coarse rotational station (13) assigned to a holding station of the grippers (5).

4. Insertion head according to Claim 3, the gripper (5) having a slewing ring (7) which can be peripherally brought into frictional engagement with at least one frictional surface (14) of the rotational device (for example 10, 11), it being possible for the frictional surface (14) to be placed in the radial direction onto the slewing ring (7) and it being possible for the gripper (5) to be rotated by a tangential relative movement between the rotational device (for example 10, 11) and the slewing ring (7), **characterized in that** the stationary frictional surface (14) of the coarse rotational device (11) extends along the path of movement of the gripper (5), which can be rotated together with the rotor (3), and **in that** the rolling section on the frictional surface (14) can be changed by the controlled infeed of the frictional surface (14) onto the slewing ring (7).

5. Insertion head according to Claim 4, **characterized in that** the coarse rotational device (11) makes possible a rotational adjustment of the gripper (5) in coarse basic steps.

6. Device according to Claim 4 or 5, **characterized in that** the frictional surface (14) is formed on a radially adjustable friction block (9) anchored on the stator.

7. Device according to Claim 6, **characterized in that** the segmented frictional surface (14) is formed by a plurality of individually adjustable friction blocks (9), the friction length of which corresponds to the angle of rotation of a basic step.

8. Device according to Claim 6 or 7, **characterized in that** the frictional surfaces (14) are shorter than the distance between two of the slewing rings (7) adjacent to one another.

## Revendications

1. Tête d'insertion (1) avec au moins un dispositif d'orientation (10, 11) pour des composants électriques (6), la tête d'insertion de type revolver (1) présentant un stator (2) et un rotor (3), sur lequel une pluralité de griffes (5) réparties de façon circulaire sont logées en soi de manière à pouvoir tourner autour d'un axe de contact,
la tête d'insertion (1) présentant un dispositif de mesure optique (8) pour la reconnaissance de position des composants (6) retenus sur les griffes (5),
la tête d'insertion (1) présentant un dispositif de rotation précise (10) disposé en suivant dans le dispositif d'orientation du rotor (3) du dispositif de mesure (8) pour l'orientation exacte des composants (6) autour de l'axe de contact dans la position de contact requise,
**caractérisée en ce que** la tête d'insertion (1) présente un dispositif de rotation approximative (11) disposé en avant dans le sens d'orientation du rotor (3) du dispositif de mesure (8) pour orienter les composants (6) autour de l'axe de contact dans une position angulaire à proximité de la position de contact.

2. Tête d'insertion selon la revendication 1, **caractérisée en ce que** le rotor (3) peut être orienté par étapes par rapport au stator (2), **en ce que** le dispositif de mesure optique est conçu comme une station de mesure (8) et **en ce que** le dispositif de rotation précise (10) est conçu comme une station de rotation précise (10) ancrée au stator.

3. Tête d'insertion selon la revendication 2, **caractérisée en ce que** le dispositif de rotation approximative ancré au stator est conçu comme une station de rotation approximative (13) associée à une station de retenue des griffes (5).

4. Tête d'insertion selon la revendication 3, dans laquelle la griffe (5) présente une couronne rotative (7) qui peut être amenée en prise en engagement par friction avec au moins une surface de friction (14) du dispositif d'orientation (10, 11), la surface de friction (14) pouvant être posée dans le sens radial sur la couronne rotative (7) et
dans laquelle la griffe (5) peut être orientée par un mouvement relatif tangentiel entre le dispositif d'orientation (10, 11) et la couronne rotative (7),
**caractérisée en ce que** la surface de friction stationnaire (14) du dispositif de rotation approximative (11) s'étend le long de la trajectoire de mouvement de la griffe (5) orientable conjointement au rotor (3) et **en ce que** la distance de roulement sur la surface de friction (14) est modifiable par l'avance commandée de la surface de friction (14) sur la couronne rotative (7).

5. Tête d'insertion selon la revendication 4, **caractérisée en ce que** le dispositif de rotation approximative (11) permet un mouvement rotatif de la griffe (5) par étapes de base approximatives.

6. Dispositif selon la revendication 4 ou 5, **caractérisé en ce que** la surface de friction (14) est conçue sur un bloc de friction (9) ancré au stator, déplaçable radialement.

7. Dispositif selon la revendication 6, **caractérisé en ce que** la surface de friction segmentée (14) est formée par plusieurs blocs de friction (9) déplaçables individuellement, dont la longueur de friction correspond à l'angle de rotation d'une étape de base.

8. Dispositif selon la revendication 6 ou 7, **caractérisé en ce que** les surfaces de friction (14) sont plus courtes que l'écartement entre deux des couronnes rotatives (7) adjacentes.
